# EUROPÄISCHE PATENTSCHRIFT

(11) **EP 2 629 422 B1**
(45) Veröffentlichungstag und Bekanntmachung des Hinweises auf die Patenterteilung: **20.08.2014**
(21) Anmeldenummer: 12155497.6
(22) Anmeldetag: 15.02.2012
(51) Int. Cl.: H03K 17/975, G06F 3/02, H01H 25/00

(54) **Kapazitiver Schalter**
Capacitive switch
Commutateur capacitif

(43) Veröffentlichungstag der Anmeldung: 21.08.2013
(73) Patentinhaber: Flextronics International Kft., Tab 8660 (HU)
(72) Erfinder: Sierak, Thaddäus, 86169 Augsburg (DE); Hornung, Heinz, 72138 Kirchentellinsfurt (DE); Richter, Silvio, 72660 Beuren (DE)
(74) Vertreter: Rupprecht, Kay

(56) Entgegenhaltungen:
- EP-A1- 0 725 482
- EP-A1- 1 739 839
- DE-A1-102009 032 614
- US-B1- 6 373 265

## Beschreibung

Die Erfindung betrifft einen kapazitiven Schalter gemäß dem Oberbegriff des Anspruchs 1.

Kapazitive Schalter der hier angesprochenen Art sind aus dem Stand der Technik bekannt. Sie weisen eine Sensorfläche und eine Bezugsfläche auf, wobei die Sensorfläche und die Bezugsfläche so ausgebildet sind, dass ein elektrisches Feld zwischen ihnen ausbildbar ist. Ein derartiger kapazitiver Schalter ist beispielsweise in der DE 21 05 071 sowie in der DE 10 2009 032 614 A1 und US 6,373,265 B1 beschrieben. Das Wirkprinzip eines kapazitiven Schalters ist es, dass sich durch Nähern eines Fingers an eine Schalterfläche oder durch eine Berührung der Schalterfläche die Kapazität zwischen der Sensorfläche und der Bezugsfläche ändert, wodurch sich wiederum weitere messbare Parameter ändern. Diese messbaren Parameter werden erfasst und ausgewertet und können somit zum Auslösen einer gewünschten Funktion dienen. Die kapazitiven Schalter der bekannten Art weisen den Nachteil auf, dass der Schaltpunkt von vielen Parametern abhängt und dadurch ein vollkommen zuverlässiges Schaltverhalten nicht gewährleistet werden kann.

Aufgabe der vorliegenden Erfindung ist es daher, einen kapazitiven Schalter zu schaffen, der eine erhöhte Zuverlässigkeit bei einer Betätigung aufweist.

Zur Lösung der oben genannten Aufgabe wird ein kapazitiver Schalter mit den Merkmalen des Anspruchs 1 vorgeschlagen, der eine Sensorfläche und eine Bezugsfläche aufweist, wobei die Sensorfläche und die Bezugsfläche im Wesentlichen in einer gemeinsamen Ebene derart angeordnet sind, dass im Betrieb des Schalters ein elektrisches Feld zwischen ihnen ausbildbar ist, und dass wenigstens eine Kopplungsfläche vorgesehen ist, die in dem elektrischen Feld angeordnet ist und bei einer Bewegung relativ zu der Sensorfläche und der Bezugsfläche eine Kapazitätsänderung zwischen der Sensorfläche und der Bezugsfläche bewirkt, und mit einem Betätigungselement zur Verlagerung der Kopplungsfläche ,
**dadurch gekennzeichnet, dass**
die Sensorfläche und die Bezugsfläche bezüglich einer Mittelachse des Betätigungselements koaxial zueinander angeordnet sind, und das Betätigungselement mit einem beweglichen scheibenförmigen Element zusammenwirkt, welches an seiner der Sensorfläche und der Bezugsfläche zugewandten Seite die Kopplungsfläche aufweist.

Ein wesentlicher Punkt der Erfindung liegt somit darin, dass durch die Anordnung der Sensorfläche und der Bezugsfläche im Wesentlichen in einer gemeinsamen Ebene und die Bereitstellung einer zusätzlichen Kopplungsfläche im Bereich des elektrischen Feldes zwischen der Sensorfläche und der Bezugsfläche eine erhöhte Zuverlässigkeit der Schaltung gegeben ist. Darüber hinaus ist ein erfindungsgemäßer kapazitiver Schalter weniger empfindlich im Hinblick auf elektromagnetische Störungen (EMV).

Besonders bevorzugt wird ein kapazitiver Schalter, bei dem die Kopplungsfläche in mehreren Raumrichtungen relativ zu der Sensorfläche und der Bezugsfläche verlagerbar ist. Vorzugsweise ist vorgesehen, dass die Bewegung der Kopplungsfläche mechanisch begrenzt ist. Weiterhin kann erfindungsgemäß vorgesehen sein, dass die Kopplungsfläche zwischen wenigstens zwei stabilen Positionen verlagert werden kann und diese Positionen einnehmen kann. Hierzu wirkt die Kopplungsfläche vorzugsweise mit einem Betätigungselement zur Verlagerung der Kopplungsfläche zusammen. Das Betätigungselement besteht vorzugsweise aus einem nichtleitenden Material, um zu verhindern, dass bei einem Nähern eines Fingers bzw. der Hand eine erkennbare Änderung der kapazitiven Kopplung und somit eine Reaktion des kapazitiven Schalters bewirkt wird.

Erfindungsgemäß kann darüber hinaus vorgesehen sein, dass eine taktile Rückmeldeeinrichtung zur Erzeugung eines vorzugsweise nichtakustischen Kommunikationshinweises bei Erreichung einer der wenigstens zwei stabilen Positionen der Kopplungsfläche vorgesehen ist. Durch die taktile Rückmeldeeinrichtung wird insbesondere mittels wenigstens zweier definierter/stabiler einnehmbarer Positionen der Kopplungsfläche eine hohe Zuverlässigkeit und eine angenehme Betätigung des kapazitiven Schalters erreicht. Die taktile Rückmeldeeinrichtung kann mit der Kopplungsfläche in einem einzigen Bauteil ausgebildet sein. Besonders bevorzugt wird eine Ausbildung, bei der die taktile Rückmeldeeinrichtung einstückig mit der Kopplungsfläche und/oder mit dem Betätigungselement ausgebildet ist. Insbesondere kann die taktile Rückmeldeeinrichtung ein Umschnappen der Kopplungsfläche bewirken, welches den Kommunikationshinweis für einen Benutzer des kapazitiven Schalters erzeugt, dass eine definierte Position erreicht wurde.

Die Erfindung wird im Folgenden anhand der Zeichnung näher erläutert.
Es zeigen:
- Fig. 1: eine schematische Darstellung eines kapazitiven Schalters gemäß der Erfindung;
- Fig. 2: eine schematische Schnittdarstellung einer ersten Ausführungsform des kapazitiven Schalters gemäß der Erfindung in einer ersten stabilen Position, und
- Fig. 3: der kapazitive Schalter gemäß Fig. 2 in einer zweiten stabilen Position.

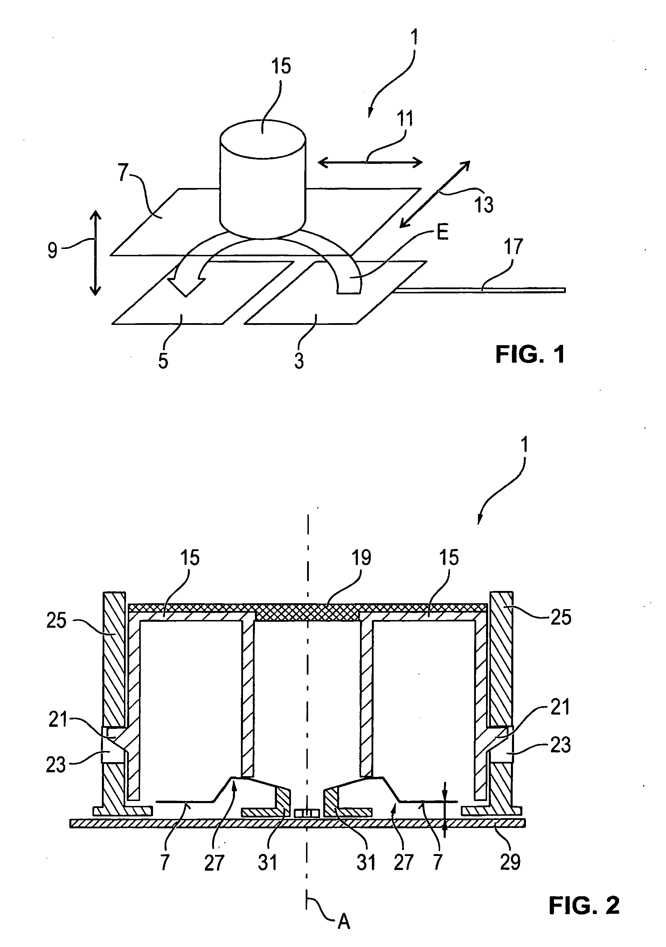

Fig. 1 zeigt eine schematische Darstellung eines kapazitiven Schalters 1 gemäß der Erfindung. Der kapazitive Schalter 1 umfasst eine Sensorfläche 3, eine Bezugsfläche 5 und eine Kopplungsfläche 7. Die Kopplungsfläche 7 ist vorzugsweise in mehrere Raumrichtungen bewegbar, wie durch die Pfeile 9, 11 und 13 in der Fig. 1 angedeutet ist. Die Kopplungsfläche 7 ist mit einem Betätigungselement 15 verbunden, wobei das Betätigungselement 15 vorzugsweise aus einem nichtleitenden Material besteht.

Die Sensorfläche 3 und die Bezugsfläche 5 sind im Wesentlichen in einer gemeinsamen Ebene angeordnet. Die Bezugsfläche 5 ist vorzugsweise mit einem Masseanschluss (GND) verbunden, während die Sensorfläche 3 über eine elektrische Zuleitung 17 mit einer in der Fig. 1 nicht gezeigten Energiequelle in Verbindung steht. Im Betrieb des kapazitiven Schalters ist zwischen der Sensorfläche 3 und der Bezugsfläche 5 ein elektrisches Feld E ausgebildet, dessen Feldlinien bogen- bzw. kreisbogenförmig zwischen der Sensorfläche 3 und der Bezugsfläche 5 verlaufen. Die Kopplungsfläche 7 ist im Bereich des elektrischen Feldes E angeordnet.

Die Funktionsweise des kapazitiven Schalters 1 ist derart, dass bei einer Verlagerung der Kopplungsfläche 7 in dem elektrischen Feld E zwischen der Bezugsfläche 5 und der Sensorfläche 3, eine Änderung der Kapazität zwischen der Sensorfläche 3 und der Bezugsfläche 5 bewirkt wird. Diese kapazitive Änderung kann durch eine entsprechende elektrische Schaltung erfasst werden und zur Auslösung einer gewünschten Funktion dienen. Die Sensorfläche 3 und die Bezugsfläche 5 sind somit mittels der Kopplungsfläche 7 kapazitiv miteinander verbunden. Die bevorzugte Bewegungsrichtung der Kopplungsfläche 7 ist die mit dem Pfeil 9 angedeutete Bewegungsrichtung, bei der die Kopplungsfläche 7 auf die Sensorfläche 3 bzw. die Bezugsfläche 5 zu und davon weg bewegt wird.

Um eine erhöhte Zuverlässigkeit des kapazitiven Schalters gemäß der Erfindung zu erzielen, ist die Kopplungsfläche 7 vorzugsweise zwischen zwei oder mehr stabilen Zuständen bzw. definierten Positionen verlagerbar. Diese stabilen Positionen der Kopplungsfläche 7 sind mit festgelegten Kapazitäten zwischen der Bezugsfläche 5 und der Sensorfläche 3 verbunden, so dass in einer definierten Position jeweils eine bestimmte Kapazität zwischen der Bezugsfläche 5 und der Sensorfläche 3 vorliegt. Erst eine entsprechend gewünschte Bewegung des Betätigungselements 15 zwischen zwei definierten Positionen löst folglich den Schaltvorgang aus.

Weiterhin kann eine taktile Rückmeldeeinrichtung vorgesehen sein, die eine undefinierte Bewegung des Betätigungselements 15 und damit der Kopplungsfläche 7 vermeidet. Beispielsweise kann ein Haptikelement in Form einer metallischen Schnappscheibe, einer Silikonmatte, einem Knallfrosch aus Kunststoff usw. vorgesehen sein. Erst wenn die Druckkraft auf das Betätigungselement den Triggerpunkt der taktilen Rückmeldeeinrichtung überschreitet, erfolgt eine weitere Verlagerung der Kopplungsfläche 7 in die zweite definierte Position. Durch eine entsprechende mechanische Gestaltung und Materialwahl, kann die Kennlinie der Druckkraft und des Triggerpunkts wunschgemäß angepasst werden.

In der Fig. 2 ist ein Ausführungsbeispiel eines kapazitiven Schalters gezeigt. In der Fig. 2 weist der kapazitive Schalter ein doppelwandig ausgebildetes, zylindrisches Betätigungselement 15 mit einer Abdeckung 19 auf, die als Berührungsfläche bzw. Druckfläche für einen Finger oder eine Hand dient. Das Betätigungselement 15 umfasst einen radialen Vorsprung 21, der in eine ringförmige Aussparung 23 eines ebenfalls zylindrischen Gehäuses 25 eingreift, wobei das Betätigungselement 15 entlang einer Mittelachse bzw. Längsachse A in dem Gehäuse 25 verlagerbar ist.

Das Betätigungselement 15 wirkt mit einem beweglichen scheibenförmigen Element 27 zusammen, welches zwischen einer Leiterplatte 29 und dem Betätigungselement 15 in dem Gehäuse 25 angeordnet ist. An seiner der Leiterplatte 29 zugewandten Seite umfasst das bewegliche Element 27 die Kopplungsfläche 7. Das bewegliche Element 27 ist an einem auf der Leiterplatte 29 gelagerten Abstützelement 31 beweglich gelagert. Auf der Leiterplatte 29 sind die Sensorfläche 3 und die Bezugsfläche 5 angeordnet, die sich in einer koaxialen Anordnung um die Mittelachse A herum erstrecken.

In der Schaltstellung gemäß Fig. 2 wird der kapazitive Schalter 1 nicht betätigt, d.h. das Betätigungselement 15 wird nicht gedrückt und befindet sich somit in einer Schaltstellung, in welcher der radiale Vorsprung 21 an dem der Leiterplatte 29 abgewandten Ende der ringförmigen Nut 23 anliegt. In dieser ersten definierten Position weist die Kopplungsfläche 7 einen Abstand s zu der Leiterplatte 29 und damit zu der Sensorfläche 3 und der Bezugsfläche 5 auf.

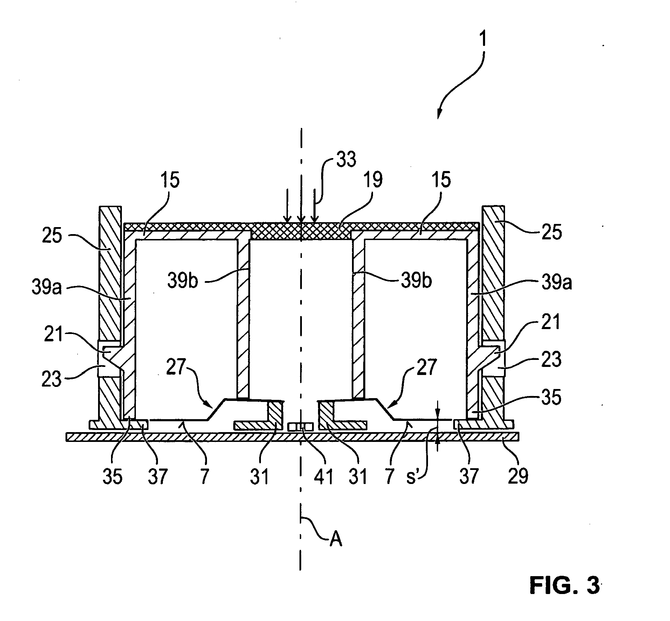

In der Fig. 3 ist der kapazitive Schalter 1 gemäß der Ausführungsform nach Fig. 2 in einer zweiten Schaltposition gezeigt. Gleiche Teile sind mit gleichen Bezugszeichen versehen, so dass insofern auf die Beschreibung zu den vorangegangenen Figuren verwiesen wird, um Wiederholungen zu vermeiden.

In der in Fig. 3 gezeigten zweiten Schaltstellung wird eine Kraft auf das Betätigungselement 15 derart ausgeübt, dass der radiale Vorsprung 21 des Betätigungselements 15 nicht mehr an dem der Leiterplatte 29 abgewandten Ende der ringförmigen Nut 23 anliegt, sondern in Richtung der Pfeile 33 und damit in Richtung der Leiterplatte 29 verlagert ist. Das Betätigungselement 15 kann so weit in dem Gehäuse 25 verlagert werden, bis ein der Leiterplatte 29 zugewandtes Ende 35 des Betätigungselements 15 an einem Anschlagelement 37 des Gehäuses 25 anstößt, wobei das Anschlagelement 37 als ein radial in das Innere des Gehäuses 25 gerichteter Vorsprung ausgebildet ist, der vorzugsweise unmittelbar benachbart zu der Leiterplatte 29 angeordnet ist und insbesondere auf dieser aufliegt. Das Anschlagelement 37 ist in der Fig. 3 einstückig mit dem Gehäuse 25 verbunden. Grundsätzlich ist es auch denkbar, dass die Leiterplatte 29 als Anschlagelement fungiert, welches die Hubbewegung des Betätigungselements 15 begrenzt.

Durch die Verlagerung des Betätigungselements 15 in Richtung der Pfeile 33 erfolgt auch eine Verlagerung des beweglichen Elements 27 und damit eine Verlagerung der Kopplungsfläche 7 in Richtung der Pfeile 33, d.h. in Richtung der Leiterplatte 29. Durch die Verlagerung des beweglichen Elements 27 ergibt sich ein verringerter Abstand s' zwischen der Kopplungsfläche 7 und der Bezugsfläche 5 bzw. der Sensorfläche 3, was zu einer Änderung der Kapazität zwischen der Bezugsfläche 5 und der Sensorfläche 3 führt. Bei der zweiten definierten Schaltstellung ist die Kapazität zwischen der Bezugsfläche 5 und der Sensorfläche eindeutig durch die in der Fig. 3 gezeigten Position des Betätigungselements 15 festgelegt, in der sich das der Leiterplatte 29 zugewandte Ende 35 an dem Anschlagelement 37 abstützt. Durch das Anschlagen des der Leiterplatte 29 zugewandte Ende 35 an dem Anschlagelement 37 wird eine entsprechende taktile Rückmeldung an einen Bediener erzeugt, der somit weiß, dass die zweite Schaltstellung erreicht wurde.

Das bewegliche Element 27 ist wie gesagt ringförmig ausgebildet und um die Längsachse A herum konzentrisch angeordnet. Vorzugsweise ist das bewegliche Element 27 derart federgelagert bzw. in einem entsprechend vorgespannten Zustand mit dem Abstützelement 31 verbunden, dass nach einem Loslassen des Betätigungselements 15 dieses automatisch in die in Fig. 2 gezeigte Ausgangsstellung des kapazitiven Schalters 1 verlagert wird. In der zylindrischen Öffnung des Abstützelements 31 kann im Übrigen ein Beleuchtungselement 41 vorgesehen sein, welches insbesondere als LED oder dergleichen Beleuchtungsmittel ausgebildet sein kann. Beispielsweise ist es denkbar, die Abdeckung 19 lichtdurchlässig auszubilden, so dass bei einer Betätigung des kapazitiven Schalters 1, d.h. also beim Herunterdrücken des Betätigungselements 15 in Richtung der Pfeile 33, ein Stromfluss zu dem Beleuchtungselement 41 derart bewirkt wird, dass ein entsprechendes Lichtsignal durch die Abdeckung 19 abgegeben wird.

Es sei an dieser Stelle noch ausgeführt, dass das Betätigungselement 15 in der in den Fig. 2 und 3 gezeigten Ausführungsform zwei koaxial zueinander angeordnete zylindrische Wandabschnitte aufweist. Dabei bildet ein radial außen liegender Zylinderabschnitt 39a des Betätigungselements 15 einen Teil der taktilen Rückmeldeeinrichtung, während ein radial innen liegender Zylinderabschnitt 39b des Betätigungselements 15 zur Betätigung des kapazitiven Schalters durch eine Verlagerung der Kopplungsfläche 7 bzw. des beweglichen Elements 27 dient. Es versteht sich, dass statt eines zylindrischen Aufbaus des Schaltelements ein quaderförmiger Aufbau oder dergleichen zum Einsatz kommen kann.

Das Betätigungselement 15 gemäß der vorliegenden Erfindung kann also eine Doppelfunktion umfassen, die zum einen in der Verlagerung der Kopplungsfläche 7 und zum anderen in der Realisierung einer taktilen Rückmeldeeinrichtung liegt, die einem Bediener einen Kommunikationshinweis liefert, wenn eine stabile Position der Kopplungsfläche 7 erreicht ist. Dieser Kommunikationshinweis ist vorzugsweise nicht akustisch.

Insgesamt zeigt sich somit, dass die vorliegende Erfindung einen vorteilhaften kapazitiven Schalter schafft, der eine erhöhte Schaltzuverlässigkeit aufweist.

### Bezugszeichenliste

- 1: Kapazitiver Schalter
- 3: Sensorfläche
- 5: Bezugsfläche
- 7: Kopplungsfläche
- 9: Pfeil
- 11: Pfeil
- 13: Pfeil
- 15: Betätigungselement
- 17: Elektrische Zuleitung
- 19: Abdeckung
- 21: Radialer Vorsprung
- 23: Ringförmige Nut
- 25: Gehäuse
- 27: Bewegliches Element
- 29: Leiterplatte
- 31: Abstützelement
- 33: Pfeil
- 35: Ende
- 37: Anschlagelement
- 39a: Radial außen liegender Zylinderabschnitt
- 39b: Radial innen liegender Zylinderabschnitt
- 41: Beleuchtungselement
- E: Elektrisches Feld
- A: Längsachse/Mittelachse
- s: Abstand
- s': Abstand

## Patentansprüche

1. Kapazitiver Schalter (1) mit einer Sensorfläche (3) und mit einer Bezugsfläche (5), wobei
die Sensorfläche (3) und die Bezugsfläche (5) im Wesentlichen in einer gemeinsamen Ebene derart angeordnet sind, dass im Betrieb des Schalters ein elektrisches Feld (E) zwischen ihnen ausbildbar ist, und dass wenigstens eine Kopplungsfläche (7) vorgesehen ist, die in dem elektrischen Feld (E) angeordnet ist und bei einer Bewegung relativ zu der Sensorfläche (3) und der Bezugsfläche (5) eine Kapazitätsänderung zwischen der Sensorfläche (3) und der Bezugsfläche (5) bewirkt, und mit einem Betätigungselement (15) zur Verlagerung der Kopplungsfläche (7),
**dadurch gekennzeichnet, dass**
die Sensorfläche (3) und die Bezugsfläche (5) bezüglich einer Mittelachse (A) des Betätigungselements (15) koaxial zueinander angeordnet sind, und das Betätigungselement (15) mit einem beweglichen scheibenförmigen Element (27) zusammenwirkt, welches an seiner der Sensorfläche (3) und der Bezugsfläche (5) zugewandten Seite die Kopplungsfläche (7) aufweist.

2. Kapazitiver Schalter nach Anspruch 1,
**dadurch gekennzeichnet, dass**
die Kopplungsfläche (7) in mehrere Raumrichtungen relativ zu der Sensorfläche (3) und der Bezugsfläche (5) verlagerbar ist.

3. Kapazitiver Schalter nach Anspruch 1 oder 2,
**dadurch gekennzeichnet, dass**
die Bewegung der Kopplungsfläche (7) mechanisch begrenzt ist.

4. Kapazitiver Schalter nach nach einem der vorhergehenden Ansprüche,
**dadurch gekennzeichnet, dass**
die Kopplungsfläche (7) wenigstens zwei stabile Positionen einnehmen kann.

5. Kapazitiver Schalter nach einem der vorhergehenden Ansprüche,
**dadurch gekennzeichnet,dass**
die Kopplungsfläche (7) mit einem Betätigungselement (15) zur Verlagerung der Kopplungsfläche (7) verbunden ist.

6. Kapazitiver Schalter nach Anspruch 5,
**dadurch gekennzeichnet, dass**
das Betätigungselement (15) aus einem nicht leitenden Material besteht.

7. Kapazitiver Schalter nach einem der vorhergehenden Ansprüche,
**dadurch gekennzeichnet,dass**
eine taktile Rückmeldeeinrichtung zur Erzeugung eines Kommunikationshinweises bei Erreichen einer der wenigstens zwei stabilen Positionen der Kopplungsfläche (7) vorgesehen ist.

8. Kapazitiver Schalter nach Anspruch 7,
**dadurch gekennzeichnet,dass**
die taktile Rückmeldeeinrichtung mit der Kopplungsfläche (7) und/oder mit dem Betätigungselement (15) ein einziges, vorzugsweise einstückig ausgebildetes Bauteil bildet.

9. Kapazitiver Schalter nach Anspruch 7 oder 8,
**dadurch gekennzeichnet, dass**
die taktile Rückmeldeeinrichtung ein Umschnappen der Kopplungsfläche (7) bewirkt.

10. Kapazitiver Schalter nach einem der vorhergehenden Ansprüche,
**dadurch gekennzeichnet, dass**
die Bezugsfläche (5) an ein Massepotential angeschlossen ist.

## Claims

1. A capacitive switch (1) having a sensor surface (3) and a reference surface (5), wherein
the sensor surface (3) and the reference surface (5) are substantially arranged in a common plane such that an electric field (E) is formed between them when the switch is operated, and that at least one coupling surface (7) is provided which is arranged in the electric field (E) and which effects a change in capacitance between the sensor surface (3) and the reference surface (5) upon a movement relative to the sensor surface (3) and the reference surface (5), as well as an actuating element (15) for displacing the coupling surface (7),
**characterized in that**
the sensor surface (3) and the reference surface (5) are coaxially arranged relative to a central axis (A) of the actuating element (15) and the actuating element (15) cooperates with a movable disc-shaped element (27) which comprises the coupling surface (7) on its side facing the sensor surface (3) and the reference surface (5).

2. The capacitive switch according to claim 1,
**characterized in that**
the coupling surface (7) is displaceable in a plurality of spatial directions relative to the sensor surface (3) and the reference surface (5).

3. The capacitive switch according to claim 1 or 2,
**characterized in that**
the movement of the coupling surface (7) is mechanically limited.

4. The capacitive switch according to any one of the preceding claims,
**characterized in that**
the coupling surface (7) can assume at least two stable positions.

5. The capacitive switch according to any one of the preceding claims,
**characterized in that**
the coupling surface (7) is connected to an actuating element (15) for displacing the coupling surface (7).

6. The capacitive switch according to claim 5,
**characterized in that**
the actuating element (15) consists of a non-conductive material.

7. The capacitive switch according to any one of the preceding claims,
**characterized in that**
a tactile feedback device for generating a reference communication upon one of the at least two stable positions of the coupling surface (7) being reached is provided.

8. The capacitive switch according to claim 7,
**characterized in that**
the tactile feedback device constitutes a single, preferably integrally formed component with the coupling surface (7) and/or actuating element (15).

9. The capacitive switch according to claim 7 or 8,
**characterized in that**
the tactile feedback device effects a snapping of the coupling surface (7).

10. The capacitive switch according to any one of the preceding claims,
**characterized in that**
the reference surface (5) is connected to a ground potential.

## Revendications

1. Commutateur capacitif (1) comprenant une surface sensitive (3) et comprenant une surface de référence (5), dans lequel la surface sensitive (3) et la surface de référence (5) sont agencées sensiblement dans un plan commun de telle façon que, en fonctionnement du commutateur, un champ électrique (E) est susceptible d'être établi entre elles, et en ce que
il est prévu au moins une surface d'accouplement (7), qui est agencée dans le champ électrique (E) et qui provoque une modification de capacité entre la surface sensitive (3) et la surface de référence (5) lors d'un mouvement par rapport à la surface sensitive (3) et à la surface de référence (5), et comprenant un élément d'actionnement (15) pour déplacer la surface d'accouplement (7),
**caractérisé en ce que**
la surface sensitive (3) et la surface de référence (5) sont agencées coaxialement l'une par rapport à l'autre par référence à un axe médian (A) de l'élément d'actionnement (15), et l'élément d'actionnement (15) coopère avec un élément mobile en forme de plaque (27), lequel comporte la surface d'accouplement (7) sur son côté tourné vers la surface sensitive (3) et vers la surface de référence (5).

2. Commutateur capacitif selon la revendication 1,
**caractérisé en ce que** la surface d'accouplement (9) est déplaçable dans plusieurs directions dans l'espace par rapport à la surface sensitive (3) et à la surface de référence (5).

3. Commutateur capacitif selon la revendication 1 ou 2,
**caractérisé en ce que** le déplacement de la surface d'accouplement (7) est limité par voie mécanique.

4. Commutateur capacitif selon l'une des revendications précédentes,
**caractérisé en ce que** la surface d'accouplement (7) est capable d'occuper au moins deux positions stables.

5. Commutateur capacitif selon l'une des revendications précédentes,
**caractérisé en ce que** la surface d'accouplement (7) est reliée à un élément d'actionnement (15) pour le déplacement de la surface d'accouplement (7).

6. Commutateur capacitif selon la revendication 5,
**caractérisé en ce que** l'élément d'actionnement (15) est en un matériau non conducteur.

7. Commutateur capacitif selon l'une des revendications précédentes,
**caractérisé en ce qu'**il est prévu un système à rétroaction tactile pour engendrer un avis de communication lorsque l'une desdites au moins deux positions stables de la surface d'accouplement (7) est atteinte.

8. Commutateur capacitif selon la revendication 7,
**caractérisé en ce que** le système à rétroaction tactile forme avec la surface d'accouplement (7) et/ou avec l'élément d'actionnement (15) un composant unique, réalisé de préférence d'une seule pièce.

9. Commutateur capacitif selon la revendication 7 ou 8,
**caractérisé en ce que** le système à rétroaction tactile provoque un saut élastique de la surface d'accouplement (7).

10. Commutateur capacitif selon l'une des revendications précédentes,
**caractérisé en ce que** la surface de référence (5) est branchée à un potentiel de masse.
